# FASCICULE DE BREVET EUROPEEN

(11) **EP 2 220 916 B1**
(45) Date de publication et mention de la délivrance du brevet: **13.04.2011**
(21) Numéro de dépôt: 08853386.4
(22) Date de dépôt: 14.11.2008
(51) Int. Cl.: H05K 1/18

(54) **DISPOSITIF DE PROTECTION DES BROCHES D'UN COMPOSANT ELECTRONIQUE**
EINRICHTUNG ZUM SCHUTZ DER ANSCHLÜSSE EINER ELEKTRONISCHEN KOMPONENTE
DEVICE FOR PROTECTING THE PINS OF AN ELECTRONIC COMPONENT

(30) Priorité: 15.11.2007 FR 0759052
(43) Date de publication de la demande: 25.08.2010
(73) Titulaire: Ingenico France, 92200 Neuilly Sur Seine (FR)
(72) Inventeur: DUBOIS, Eric, F-26120 Montvendre (FR)
(74) Mandataire: de Beaumont, Michel
(86) Numéro de dépôt international: PCT/FR2008/052052
(87) Numéro de publication internationale: WO 2009/068827

(56) Documents cités:
- DE-A1- 3 405 804
- JP-A- 10 190 156
- US-A- 5 276 572
- US-A1- 2005 232 095

## Description

### Domaine de l'invention

La présente invention concerne un dispositif de protection des broches d'un composant électronique, par exemple une tête de lecture magnétique.

### Exposé de l'art antérieur

Un lecteur de chèque ou un lecteur de carte magnétique comprend généralement une tête de lecture magnétique connectée à un circuit imprimé, généralement appelé carte mère du lecteur. La tête de lecture magnétique comprend un corps rigide contenant les composants internes de la tête et des bornes d'accès. Les bornes d'accès correspondent à des broches métalliques qui se projettent depuis le corps de la tête de lecture et permettent la transmission des signaux mesurés par la tête de lecture. Les connexions entre les broches de la tête de lecture et la carte mère peuvent être réalisées par des liaisons filaires. Document JP-A-10 190115b décrit un circuit imprimé souple avec une ouverture dans laquelle une broche d'un composant électronique est destinée à être insérée.

De façon générale, la carte mère et la tête de lecture sont disposées dans un boîtier dans lequel sont prévus des dispositifs de protection destinés à détecter un accès non autorisé à la carte mère. Un exemple de dispositif de protection correspond à une membrane souple recouvrant au moins en partie la carte mère et dans laquelle est prévue une piste conductrice en forme de treillis. Les extrémités de la piste conductrice sont reliées à un circuit de protection prévu au niveau de la carte mère. Une tentative d'accès à la carte mère se traduit généralement par une interruption de la piste conductrice de la membrane. Ceci est détecté par le circuit de protection et entraîne, par exemple, l'arrêt du fonctionnement du lecteur.

Toutefois, notamment en raison de la position de la tête de lecture par rapport à la carte mère dans le boîtier du lecteur, il n'est généralement pas possible de protéger la tête de lecture au moyen des dispositifs de protection classiques de la carte mère. Un individu pourrait alors accéder aux broches de la tête de lecture et recueillir les signaux transmis sur ces broches sans qu'une telle opération ne soit détectée par les dispositifs de protection classiques du lecteur.

Pour protéger les broches de la tête de lecture, il est nécessaire de prévoir un dispositif de protection qui lui soit dédié. Une possibilité consiste à encapsuler en partie la tête de lecture dans un capot rigide auquel est associé un dispositif de protection, par exemple du type membrane à treillis. Toutefois, il existe de nombreux types de lecteurs différents, et donc de positionnements différents de la tête de lecture et de la carte mère dans le boîtier du lecteur. La forme du capot doit alors être adaptée au cas par cas en fonction des positions de la tête de lecture et de la carte mère dans le boîtier. Le coût d'un dispositif de protection à capot est donc élevé.

### Résumé de l'invention

La présente invention vise un dispositif de protection des broches d'un composant électronique, par exemple une tête de lecture magnétique, destiné à être relié à un système électronique, par exemple un circuit imprimé, qui autorise une certaine liberté lors du positionnement du composant électronique par rapport au système électronique et qui est susceptible d'être réalisé à coût réduit.

Ainsi, il est prévu un dispositif de protection d'un composant électronique comprenant au moins une broche destinée à être reliée électriquement à un système électronique. Le dispositif comprend au moins un circuit imprimé souple comprenant des première et seconde faces opposées, une portion centrale comprenant une ouverture traversante dans laquelle est destinée à être insérée la broche, et des volets reliés à la portion centrale. Le circuit imprimé souple est au moins en partie constitué de l'empilement de deux couches isolantes et comporte au moins une première piste conductrice entre les deux couches isolantes destinée à relier électriquement la broche au système électronique, une deuxième piste conductrice s'étendant sur la première face et une troisième piste conductrice s'étendant sur la seconde face. Les volets sont adaptés à être rabattus au moins en partie les uns sur les autres pour encapsuler la broche et relier électriquement les deuxième et troisième pistes conductrices, d'où il résulte que les deuxième et troisième pistes conductrices forment une piste de protection destinée à être reliée électriquement au système électronique.

Selon un mode de réalisation, le dispositif comprend une entretoise adaptée à être disposée entre la portion centrale et les volets.

Selon un mode de réalisation, l'entretoise comprend une ouverture supplémentaire dans laquelle est destinée à être insérée la broche.

Selon un mode de réalisation, l'entretoise comprend une ouverture filetée, le dispositif comprenant une vis comportant une tige filetée adaptée à coopérer avec l'ouverture filetée et une tête adaptée à appliquer lesdits volets contre l'entretoise.

Selon un mode de réalisation, les deuxième et troisième pistes conductrices sont en carbone.

Selon un mode de réalisation, la troisième piste conductrice comprend une portion conductrice élargie au niveau d'un premier volet parmi lesdits volets, la portion conductrice élargie étant adaptée à être collée à la première face d'un second volet parmi lesdits volets.

Selon un mode de réalisation, la deuxième piste conductrice comprend une première pastille conductrice au niveau d'un premier volet parmi lesdits volets et la troisième piste conductrice comprend une seconde pastille conductrice au niveau d'un second volet parmi lesdits volets, les premier et second volets étant adaptés à être repliés l'un contre l'autre pour mettre en contact électrique la première pastille conductrice avec la seconde pastille conductrice.

Il est également prévu un procédé de protection d'un composant électronique comprenant au moins une broche destinée à être reliée électriquement à un système électronique. Le procédé comprend les étapes consistant à prévoir un dispositif de protection comprenant au moins un circuit imprimé souple comportant des première et seconde faces opposées, une portion centrale comprenant une ouverture traversante et des volets reliés à la portion centrale, le circuit imprimé souple étant au moins en partie constitué de l'empilement de deux couches et comportant au moins une première piste conductrice entre les deux couches, une deuxième piste conductrice s'étendant sur la première face et une troisième piste conductrice s'étendant sur la seconde face, à insérer la broche dans l'ouverture, à connecter la première piste conductrice à la broche, et à rabattre au moins en partie les volets les uns contre les autres pour encapsuler la broche et relier électriquement les deuxième et troisième pistes conductrices, d'où il résulte que les deuxième et troisième pistes conductrices forment une piste de protection destinée à être reliée électriquement au système électronique.

Selon un mode de réalisation, le procédé comprend, en outre, les étapes consistant à disposer une entretoise contre la portion centrale et à rabattre au moins en partie les volets contre l'entretoise.

Selon un mode de réalisation, la troisième piste conductrice comprend une portion conductrice élargie au niveau d'un premier volet parmi lesdits volets. Le procédé comprend, en outre, l'étape consistant à coller la portion conductrice élargie à la première face d'un second volet parmi lesdits volets.

### Brève description des dessins

Ces objets, caractéristiques et avantages, ainsi que d'autres seront exposés en détail dans la description suivante d'un exemple de réalisation particulier faite à titre non-limitatif en relation avec les figures jointes parmi lesquelles :
les figures 1 et 2 sont des vues éclatées, en perspective avant et arrière, des éléments d'un exemple de réalisation d'un dispositif de protection d'une tête de lecture magnétique ;
les figures 3A à 3F illustrent des étapes successives d'un exemple de procédé de montage du dispositif de protection des figures 1 et 2 à une tête de lecture magnétique ; et
la figure 4 est une coupe schématique et partielle d'une variante du dispositif de protection.

### Description détaillée

Par souci de clarté, de mêmes éléments ont été désignés par de mêmes références aux différentes figures.

Un exemple de réalisation d'un dispositif de protection va maintenant être décrit pour la protection des broches d'une tête de lecture magnétique reliée à une carte mère d'un lecteur, notamment un lecteur de chèque ou de carte magnétique. Toutefois, la présente invention peut s'appliquer à la protection des broches de n'importe quel composant électronique qui doit être connecté à un système électronique tout en permettant, dans une certaine mesure, un déplacement relatif entre le composant électronique et le système électronique.

Le principe de la présente invention consiste à relier la tête de lecture magnétique à la carte mère du lecteur par l'intermédiaire d'un circuit imprimé souple qui, en plus de relier électriquement les broches de la tête de lecture à des plots de connexion de la carte mère, protège les broches de la tête de lecture contre un accès non autorisé. On bénéfice alors du faible coût de fabrication d'un circuit imprimé souple. En outre, le circuit imprimé souple peut, au moins en partie, se déformer. Un même circuit imprimé souple peut donc être utilisé alors que la tête de lecture magnétique et la carte mère sont à des positions relatives différentes.

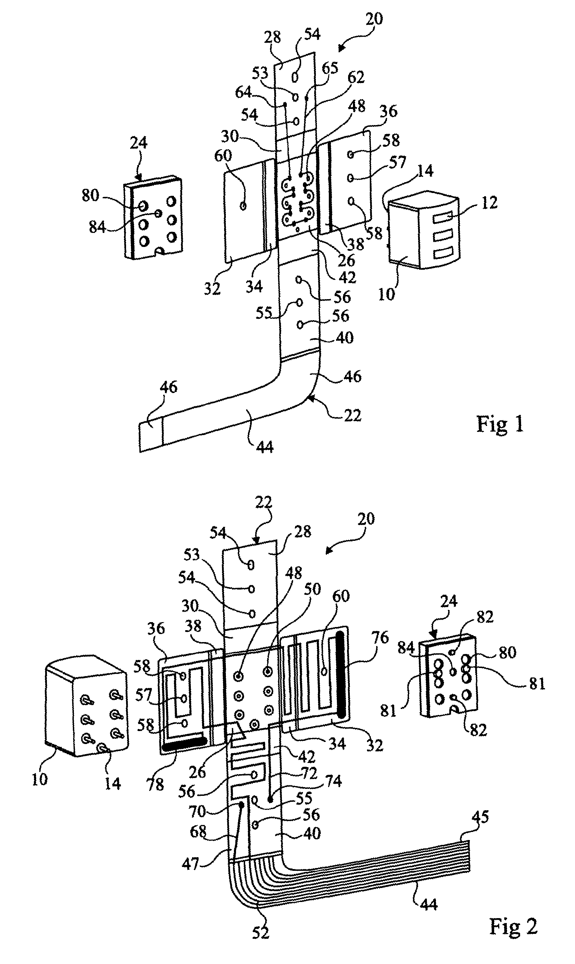

Les figures 1 et 2 sont des vues éclatées, en perspective avant et arrière, d'une tête de lecture magnétique 10 et des éléments d'un exemple de réalisation d'un dispositif de protection 20. La tête de lecture 10 comprend, dans le présent exemple, trois fentes 12 en face avant et des broches 14 en face arrière. Chaque broche 14 correspond, par exemple, à une tige métallique de quelques millimètres de hauteur. Le dispositif de protection 20 comprend un circuit imprimé souple 22 et une entretoise 24. A titre d'exemple, le circuit imprimé souple 22 est constitué d'une membrane souple, de l'ordre de 0,1 mm d'épaisseur, par exemple en kapton (marque déposée par Dupont De Nemours), sur une face de laquelle sont réparties des pistes conductrices, appelées pistes conductrices internes dans la suite de la description, par exemple en cuivre. Le circuit imprimé souple est recouvert d'un vernis isolant du côté des pistes conductrices internes. D'autres pistes conductrices, appelées pistes conductrices externes dans la suite de la description, par exemple en carbone ou en encre argent, sont réparties sur la couche de vernis et sur la face de la membrane opposée aux pistes conductrices internes.

Dans le présent exemple, le circuit imprimé souple 22 comprend une portion centrale 26 de forme sensiblement rectangulaire. Un volet supérieur 28 est relié au bord supérieur de la portion centrale 26 par une première portion de raccord 30. Un premier volet latéral 32 est relié à un bord latéral de la portion centrale 26 par une portion de raccord 34. Un second volet latéral 36 est relié au bord latéral opposé de la portion centrale 26 par une portion de raccord 38 et un volet inférieur 40 est relié au bord inférieur de la portion centrale 26 par une portion de raccord 42. Le volet inférieur 40 se prolonge par une portion de connexion 44 comprenant à son extrémité une zone de connexion 45 destinée à être connectée à la carte mère du lecteur. A titre d'exemple, chaque volet 28, 32, 36, 40 et chaque portion de raccord 30, 34, 38, 42 a une forme sensiblement rectangulaire. On appelle face avant 46 du circuit imprimé souple 22 la face visible en figure 1 et face arrière 47 du circuit imprimé souple 22 la face visible en figure 2. A titre d'exemple, la couche de vernis isolant recouvrant la membrane formant le circuit imprimé souple 22 est disposée du côté de la face arrière 47 de sorte que les pistes conductrices externes prévues du côté de la face arrière 47 peuvent être connectées à des pistes conductrices internes par de simples ouvertures prévues dans la couche de vernis.

La portion centrale 26 est traversée par sept ouvertures circulaires 48 réparties de façon analogue aux broches 14 de la tête de lecture 10. Des anneaux conducteurs 50 entourent chaque ouverture 48 sur la face arrière 47 de la portion centrale 26. Chaque anneau conducteur 50 est connecté à l'une des pistes conductrices internes du circuit imprimé souple 22 qui relie l'anneau conducteur 50 à la zone de connexion 45, ces pistes conductrices internes étant représentées seulement au niveau de la portion de connexion 44 et de la zone de connexion 45.

Le volet supérieur 28 est traversé par une ouverture centrale 53 et deux ouvertures 54 réparties de part et d'autre de l'ouverture centrale 53. Le volet inférieur 40 est traversé par une ouverture centrale 55 et deux ouvertures 56 réparties de part et d'autre de l'ouverture centrale 55. Le volet latéral 36 est traversé par une ouverture centrale 57 et deux ouvertures 58 réparties de part et d'autre de l'ouverture centrale 57. Le volet latéral 32 est traversé par une ouverture centrale 60.

Des pistes conductrices internes, par exemple en cuivre, et des pistes conductrices externes (également appelées éventuellement pastilles ou portions agrandies par la suite), par exemple en carbone ou en encre argent, sont dédiées à la protection des broches de la tête de lecture 10. Plus précisément, comme cela est représenté en figure 1, le circuit imprimé souple 22 comprend, en face avant 46, une piste conductrice externe 62 qui serpente autour des ouvertures 48 de la portion centrale 26 et qui relie deux pastilles conductrices externes 64, 65, prévues au niveau du volet supérieur 28. Comme cela est représenté en figure 2, en face arrière 47, le circuit 22 comprend une piste conductrice interne 68 qui est connectée à une pastille conductrice externe 70 prévue au niveau du volet inférieur 40 et qui s'étend jusqu'à la zone de connexion 45. En face arrière 47, le circuit 22 comprend, en outre, une piste conductrice interne 72 qui est connectée à une pastille conductrice externe 74 prévue au niveau du volet inférieur 40 et qui s'étend jusqu'à la zone de connexion 45. La piste conductrice interne 72 serpente au niveau des volets latéraux 32 et 36, de la portion centrale 26, des portions de raccord 34, 38, 42 et du volet inférieur 40. Deux portions conductrices élargies externes 76, 78 sont prévues sur le parcours de la piste conductrice 72 à laquelle elles sont connectées, une première portion conductrice élargie externe 76 au niveau du volet latéral 32 et une seconde portion conductrice élargie externe 78 au niveau du volet latéral 36. La disposition des pistes conductrices internes 68, 72 et de la piste conductrice externe 62 sur les figures 1 et 2 est donnée simplement à titre d'exemple et pourrait être différente de ce qui est représenté.

L'entretoise 24 a une forme générale parallélépipédique dont la grande face a sensiblement les mêmes dimensions que la portion centrale 26. L'entretoise 24 est traversée par sept ouvertures 80 réparties sensiblement comme les broches 14 de la tête de lecture 10. Elle comprend également sur une face deux protubérances 81 et deux plots 82 qui se projettent en saillie. Enfin elle comprend une ouverture 84, éventuellement filetée.

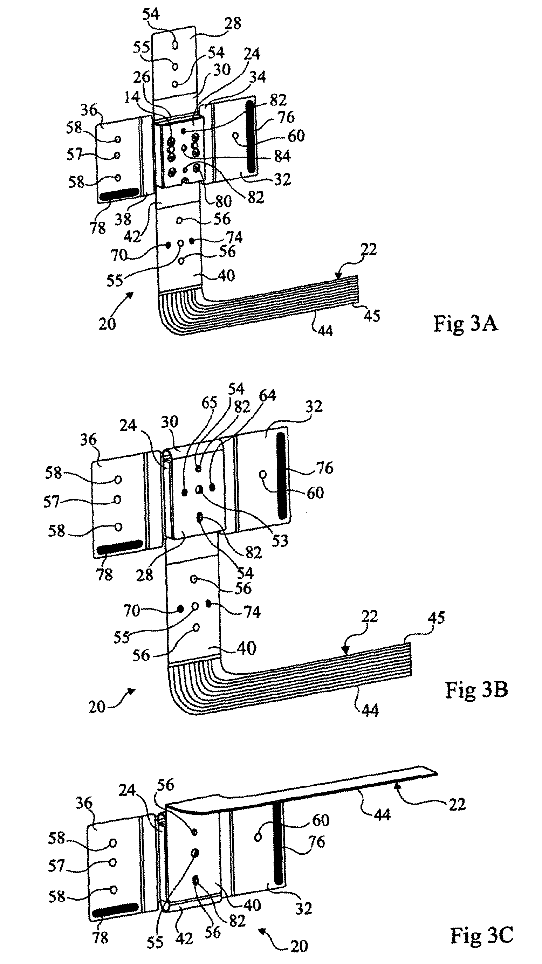

Les figures 3A à 3F sont des vues en perspective arrière illustrant des étapes successives d'un exemple de procédé de montage du dispositif de protection 20 sur la tête de lecture 10. Sur ces figures, seules les pastilles conductrices externes 64, 65, 70, 74 et les portions conductrices élargies externes 76, 78 sont représentées.

La figure 3A représente le dispositif de protection 20 après avoir réalisé les étapes suivante:
collage de la tête de lecture 10 sur la face avant 46 de la portion centrale 26 du circuit imprimé souple 22 avec insertion des broches 14 de la tête de lecture 10 dans les ouvertures 48 de la portion centrale 26 ;
soudure des broches 14 aux anneaux conducteurs 50 du côté de la face arrière 47 du circuit imprimé souple 22 ; et
mise en place de l'entretoise 24 contre la portion centrale 26 du côté de la face arrière 47 du circuit souple 22 par insertion des broches 14 dans les ouvertures 80 de l'entretoise 24, les plots 82 étant disposés du côté opposé à la portion centrale 26. De préférence, l'épaisseur de l'entretoise 24 est choisie pour que les broches 14 ne dépassent pas de l'entretoise 24.

La figure 3B représente le dispositif de protection 20 une fois que le volet supérieur 28 a été rabattu contre l'entretoise 24. La portion de raccord 30 entre la portion centrale 26 et le volet supérieur 28 adopte une forme recourbée pour permettre le rabattement du volet supérieur 28. L'épaisseur de l'entretoise 24, par exemple de quelques millimètres, assure que le rayon de courbure de la portion de raccord 30 n'est pas trop faible. Les ouvertures 54 du volet supérieur 28 sont disposées de façon que, après rabattement du volet supérieur 28, les plots 82 de l'entretoise 24 pénètrent dans celles-ci ce qui assure un positionnement convenable du volet supérieur 28 sur l'entretoise 24. L'ouverture centrale 53 du volet supérieur 28 se trouve, après rabattement, dans le prolongement de l'ouverture 84 de l'entretoise 24. Les protubérances 81 sont disposées sur l'entretoise 24 de façon à se trouver, après rabattement du volet supérieur 28, au niveau des pastilles conductrices 64, 65.

La figure 3C représente le dispositif de protection 20 après avoir rabattu le volet inférieur 40 contre le volet supérieur 28. La portion de raccord 42 entre le volet inférieur 40 et la portion centrale 26 adopte une forme recourbée pour permettre le rabattement du volet inférieur 40. Les ouvertures 56 du volet inférieur 40 sont disposées de façon que, après rabattement du volet inférieur 40, les plots 82 de l'entretoise 24 pénètrent dans celles-ci, ce qui assure un positionnement convenable du volet inférieur 40 sur le volet supérieur 28. L'ouverture centrale 55 du volet inférieur 40 se trouve, après rabattement, dans le prolongement de l'ouverture 84 de l'entretoise 24. Après rabattement du volet inférieur 40, la pastille conductrice externe 70 du volet inférieur 40 est en appui contre la pastille conductrice externe 65 du volet supérieur 28 et la pastille conductrice externe 74 du volet inférieur 40 est en appui contre la pastille conductrice externe 64 du volet supérieur 28. Une colle conductrice peut être appliquée au préalable sur les pastilles conductrices externes 64, 65, 70, 74 pour améliorer la connexion électrique entre celles-ci. La piste conductrice externe 62 est alors électriquement connectée à la piste conductrice interne 68 par la connexion des pastilles 65 et 70 et est électriquement connectée à la piste conductrice interne 72 par la connexion des pastilles 64 et 74. Les protubérances 81 permettent d'assurer un bon contact entre les pastilles 64 et 70 d'une part et les pastilles 65 et 74 d'autre part lors du rabattement du volet inférieur 40. Les pistes conductrices 68, 62 et 72 sont ainsi reliées en série de sorte qu'on obtienne une piste de protection continue parcourant le circuit imprimé souple 22 et qui est reliée, aux extrémités, à la zone de connexion 45.

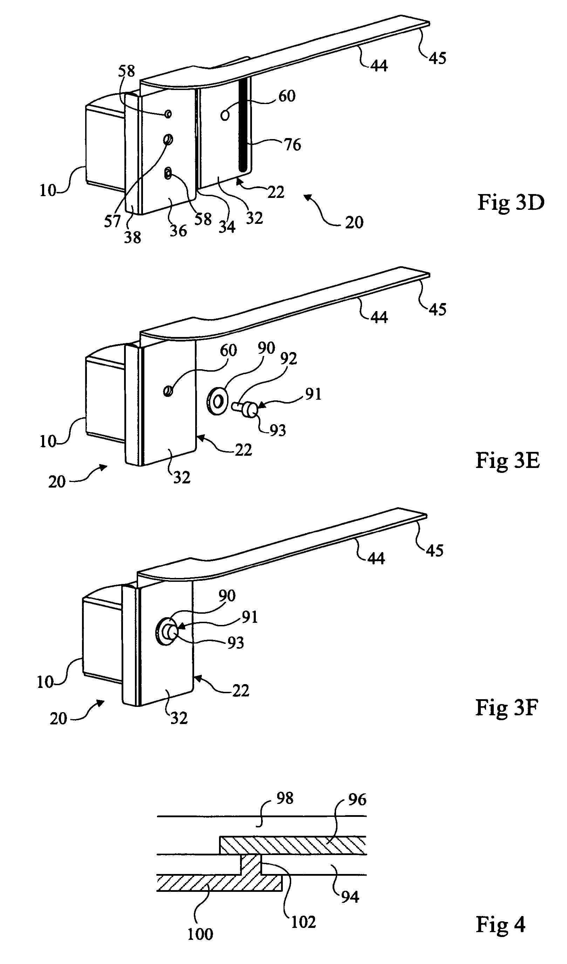

La figure 3D représente le dispositif de protection 20 après avoir rabattu le volet latéral 36 contre le volet inférieur 40. La portion de raccord 38 est pliée au moins en partie pour permettre le rabattement du volet latéral 36. Les ouvertures 58 du volet latéral 36 sont disposées de façon que, après rabattement du volet latéral 36, les plots 82 de l'entretoise 24 pénètrent dans celles-ci ce qui assure un positionnement convenable du volet latéral 36 sur le volet inférieur 40. L'ouverture centrale 57 du volet latéral 36 se trouve, après rabattement, dans le prolongement de l'ouverture 84 de l'entretoise 24. Avant le rabattement du volet latéral 36, de la colle est appliquée au niveau de la portion conductrice externe élargie 78 assurant ainsi la fixation du volet latéral 36 au volet inférieur 40 après rabattement.

La figure 3E représente la structure obtenue après avoir rabattu le volet latéral 32 sur le volet latéral 36. La portion de raccord 34 est pliée au moins en partie pour permettre le rabattement du volet latéral 32. L'ouverture centrale 60 du volet latéral 32 se trouve, après rabattement, dans le prolongement de l'ouverture 84 de l'entretoise 24. Avant le rabattement du volet latéral 32, de la colle est appliquée au niveau de la portion conductrice externe 76 assurant la fixation du volet latéral 32 au volet latéral 36 après rabattement. En figure 3E, on a également représenté une rondelle 90 et une vis 91. La vis 91 comprend une tige filetée 92 et une tête 93.

La figure 3F représente la structure obtenue après avoir vissé la tige 92 de la vis 91 dans l'ouverture filetée 84 de l'entretoise 24, la rondelle 90 étant interposée entre le volet latéral 32 et la tête 93 de la vis 91. La tête 93 de la vis 91 plaque alors les volets 28, 32, 36, 40 contre l'entretoise 24.

Le circuit imprimé souple 22 peut alors être connecté à la carte mère du lecteur au niveau de la zone de connexion 45 de la portion de connexion 44. La portion de connexion 44 étant souple, elle peut être "déformée" pour s'adapter à la position relative entre la tête de lecture 10 et la carte mère.

Selon une variante de l'exemple de réalisation décrit précédemment, la cohésion du dispositif de protection 20 est seulement assurée par les zones de collage prévues au niveau des portions conductrices externes élargies 76, 78. La vis 92 peut alors ne pas être présente. Selon une autre variante, la pression assurée par la vis 92 est suffisante pour assurer un appui convenable entre les pastilles 64, 65 et les pastilles 70, 74. Il peut alors ne pas être nécessaire de prévoir de la colle conductrice reliant les pastilles 64, 65 aux pastilles 70, 74.

Lorsque le circuit imprimé souple 22 est connecté à la carte mère, les pistes conductrices externes 68, 72 et la piste conductrice interne 62 forment une piste continue qui est reliée à un circuit de protection prévu au niveau de la carte mère. Le circuit de protection est adapté à détecter une interruption des pistes conductrices 62, 68, 72, ce qui peut correspondre à une tentative d'accès non autorisé aux broches 14 de la tête de lecture 10. Le circuit de protection peut alors commander l'arrêt du lecteur et l'effacement de toutes les données sensibles stockées au niveau de la carte mère. A titre d'exemple, une interruption de la piste conductrice 62 se produit par arrachement lors d'une tentative de retrait de la tête de lecture 10 du dispositif de protection 20. Selon un autre exemple, si un individu retire la vis 92 et cherche à déployer le volet latéral 32, ceci se traduit par un arrachement de la portion conductrice élargie 76 et donc par une rupture de la piste conductrice 72. Les portions conductrices externes élargies 76 et 78 servent alors de fusibles car elles sont collées respectivement sur les volets 36 et 44 et se déchirent en cas d'ouverture des volets. Une interruption des pistes conductrices 62, 68, 72 peut également correspondre à une tentative de dégradation, par exemple de découpage, du circuit imprimé souple 22.

Dans l'exemple de réalisation décrit précédemment, la piste conductrice externe 62 est reliée aux pistes conductrices internes 68, 72 par l'intermédiaire des pastilles 64, 65, 70 et 74. Selon une variante, la piste conductrice externe 62 peut être reliée aux pistes 68, 72 par des vias traversant la membrane du circuit imprimé souple 22. Ceci permet d'éviter que la piste conductrice externe 62 ne s'étende sur la portion de raccord 30 où elle est alors directement accessible.

La figure 4 est une vue en coupe schématique d'une partie du circuit imprimé souple 22 comprenant une membrane souple 94, une piste conductrice interne 96, par exemple en cuivre formée sur la membrane 94, une couche de vernis isolant 98 recouvrant la piste conductrice interne 96, une piste conductrice externe 100, par exemple en carbone, disposée du côté de la membrane 94 opposé à la piste conductrice interne 96. Selon la variante décrite précédemment, la piste conductrice externe 100 est connectée à la piste conductrice interne 96 par un via 102 traversant la membrane 94.

Des modes de réalisation particuliers de la présente invention ont été décrits. Diverses variantes et modifications apparaîtront à l'homme de l'art. En particulier, le nombre et la forme des volets peuvent être adaptés à la forme de la tête de lecture.

## Revendications

1. Dispositif de protection (20) d'un composant électronique (10) comprenant au moins une broche (14) destinée à être reliée électriquement à un système électronique, le dispositif comprenant au moins un circuit imprimé souple (22) comprenant des première et seconde faces opposées (46, 47), une portion centrale (26) comprenant une ouverture (48) traversante dans laquelle est destinée à être insérée la broche, et **caractérisé en ce que** le circuit imprimé souple comprend des volets (28, 32, 36, 40) reliés à la portion centrale, le circuit imprimé souple étant au moins en partie constitué de l'empilement de deux couches isolantes (94, 98) et comportant au moins une première piste conductrice (52) entre les deux couches isolantes destinée à relier électriquement la broche au système électronique, une deuxième piste conductrice (62, 64, 65) s'étendant sur la première face et une troisième piste conductrice (70, 74, 76, 78) s'étendant sur la seconde face, les volets étant adaptés à être rabattus au moins en partie les uns sur les autres pour encapsuler la broche, les deuxième et troisième pistes conductrices étant adaptées à être reliées électriquement entre elles au moins lorsque les volets sont rabattus au moins en partie les uns sur les autres, d'où il résulte que les deuxième et troisième pistes conductrices forment au moins une partie d'une piste de protection destinée à être reliée électriquement au système électronique.

2. Dispositif selon la revendication 1, comprenant une entretoise (24) adaptée à être disposée entre la portion centrale (26) et les volets (28, 32, 36, 40).

3. Dispositif selon la revendication 2, dans lequel l'entretoise (24) comprend une ouverture supplémentaire (84) dans laquelle est destinée à être insérée la broche (14).

4. Dispositif selon la revendication 2 ou 3, dans lequel l'entretoise (24) comprend une ouverture filetée (84), le dispositif (20) comprenant une vis (91) comportant une tige filetée (92) adaptée à coopérer avec l'ouverture filetée et une tête (93) adaptée à appliquer lesdits volets (28, 32, 36, 40) contre l'entretoise (24).

5. Dispositif selon l'une quelconque des revendications précédentes, dans lequel les deuxième et troisième pistes conductrices (62, 68, 72) sont en carbone.

6. Dispositif selon l'une quelconque des revendications précédentes, dans lequel la troisième piste conductrice comprend une portion conductrice élargie (76, 78) au niveau d'un premier volet (32, 36) parmi lesdits volets (28, 32, 36, 40), la portion conductrice élargie étant adaptée à être collée à la première face (46) d'un second volet (40, 36) parmi lesdits volets.

7. Dispositif selon l'une quelconque des revendications précédentes, dans lequel la deuxième piste conductrice (62) comprend une première pastille conductrice (64, 65) au niveau d'un premier volet (28) parmi lesdits volets (28, 32, 36, 40) et dans lequel la troisième piste conductrice comprend une seconde pastille conductrice (70, 74) au niveau d'un second volet (40) parmi lesdits volets, les premier et second volets étant adaptés à être repliés l'un contre l'autre pour mettre en contact électrique la première pastille conductrice avec la seconde pastille conductrice.

8. Procédé de protection d'un composant électronique (10) comprenant au moins une broche (14) destinée à être reliée électriquement à un système électronique, le procédé comprenant les étapes suivante:
prévoir un dispositif de protection comprenant au moins un circuit imprimé souple (22) comportant des première et seconde faces opposées (46, 47), une portion centrale (46) comprenant une ouverture (48) traversante et des volets (28, 32, 36, 40) reliés à la portion centrale, le circuit imprimé souple étant au moins en partie constitué de l'empilement de deux couches (94, 98) et comportant au moins une première piste conductrice (52) entre les deux couches, une deuxième piste conductrice (62) s'étendant sur la première face et une troisième piste conductrice (68, 72) s'étendant sur la seconde face ;
insérer la broche dans l'ouverture;
connecter la première piste conductrice à la broche ; et
rabattre au moins en partie les volets les uns contre les autres pour encapsuler la broche, les deuxième et troisième pistes conductrices étant reliées électriquement entre elles au moins lorsque les volets sont rabattus au moins en partie les uns sur les autres, d'où il résulte que les deuxième et troisième pistes conductrices forment au moins une partie d'une piste de protection destinée à être reliée électriquement au système électronique.

9. Procédé selon la revendication 8, comprenant, en outre, les étapes consistant à disposer une entretoise (24) contre la portion centrale (26) et à rabattre au moins en partie les volets (28, 32, 36, 40) contre l'entretoise.

10. Procédé selon la revendication 8 ou 9, dans lequel la troisième piste conductrice (68, 72) comprend une portion conductrice élargie (76, 78) au niveau d'un premier volet (32, 36) parmi lesdits volets (28, 32, 36, 40), le procédé comprenant, en outre, l'étape consistant à coller la portion conductrice élargie à la première face (46) d'un second volet (40, 36) parmi lesdits volets.

## Claims

1. A device (20) for protecting an electronic component (10) comprising at least one pin (14) to be electrically connected to an electronic system, the device comprising at least one flexible printed circuit (22) comprising first and second opposite surfaces (46, 47), a central portion (26) comprising a through opening (48) into which the pin is to be inserted, and **characterized in that** the flexible printed circuit comprises flaps (28, 32, 36, 40) connected to the central portion, the flexible printed circuit being at least partly formed of the stack of two insulating layers (94, 98) and comprising at least a first conductive track (52) between the two insulating layers, for electrically connecting the pin to the electronic system, a second conductive track (62, 64, 65) extending on the first surface, and a third conductive track (70, 74, 76, 78) extending on the second surface, the flaps being capable of being at least partly folded back on one another to encapsulate the pin, the second and third conductive tracks being capable of being electrically connected to each other at least when the flaps are at least partly folded back on one another, whereby the second and third conductive tracks form at least a portion of a protection track to be electrically connected to the electronic system.

2. The device of claim 1, comprising a spacer (24) capable of being arranged between the central portion (26) and the flaps (28, 32, 36, 40).

3. The device of claim 2, wherein the spacer (24) comprises an additional opening (84) into which the pin is to be inserted (14).

4. The device of claim 2 or 3, wherein the spacer (24) comprises a threaded opening (84), the device (20) comprising a screw (91) having a threaded rod (92) capable of cooperating with the threaded opening and a head (93) capable of applying said flaps (28, 32, 36, 40) against the spacer (24).

5. The device of any of the foregoing claims, wherein the second and third conductive tracks (62, 68, 72) are made of carbon.

6. The device of any of the foregoing claims, wherein the third conductive track comprises a widened conductive portion (76, 78) at the level of a first flap (32, 36) from among said flaps (28, 32, 36, 40), the widened conductive portion being capable of being glued to the first surface (46) of a second flap (40, 36) from among said flaps.

7. The device of any of the foregoing claims, wherein the second conductive track (62) comprises a first conductive land (64, 65) at the level of a first flap (28) from among said flaps (28, 32, 36, 40) and wherein the third conductive track comprises a second conductive land (70, 74) at the level of a second flap (40) from among said flaps, the first and second flaps being capable of being folded back against each other to put the first conductive land in electric contact with the second conductive land.

8. A method for protecting an electronic component (10) comprising at least one pin (14) to be electrically connected to an electronic system, the method comprising the steps of:
providing a protection device comprising at least one flexible printed circuit (22) comprising first and second opposite surfaces (46, 47), a central portion (46) comprising a through opening (48), and flaps (28, 32, 36, 40) connected to the central portion, the flexible printed circuit being at least partly formed of the stack of two insulating layers (94, 98) and comprising at least a first conductive track (52) between the two layers, a second conductive track (62) extending on the first surface, and a third conductive track (68, 72) extending on the second surface;
inserting the pin into the opening;
connecting the first conductive track to the pin; and
at least partly folding back the flaps against one another to encapsulate the pin, the second and third conductive tracks being capable of being electrically connected to each other at least when the flaps are at least partly folded back on one another, whereby the second and third conductive tracks form a protection track to be electrically connected to the electronic system.

9. The method of claim 8, further comprising the steps of arranging a spacer (24) against the central portion (26) and of at least partly folding back the flaps (28, 32, 36, 40) against the spacer.

10. The method of claim 8 or 9, wherein the third conductive track (68, 72) comprises a widened conductive portion (76, 78) at the level of a first flap (32, 36) from among said flaps (28, 32, 36, 40), the method further comprising the step of gluing the widened conductive portion to the first surface (46) of a second flap (40, 36) from among said flaps.

## Patentansprüche

1. Eine Vorrichtung (20) zum Schutz einer elektronischen Komponente (10), die mindestens einen elektrisch mit einem Elektroniksystem verbindbaren Pin (14), und mindestens eine flexible gedruckte Schaltung (22) aufweist, die erste und zweite entgegengesetzte Oberflächen (46, 47) und einen Mittelteil (26) besitzt, der eine Durchgangsöffnung (48), in die der Pin einzusetzen ist, aufweist wobei die Vorrichtung **dadurch gekennzeichnet ist, dass** die flexible gedruckte Schaltung mit dem Mittelteil verbundene Klappen oder Flügel (28, 32, 36, 40) aufweist, und wobei die flexible gedruckte Schaltung mindestens teilweise gebildet ist aus dem Stapel von zwei Isolierschichten (94, 98) und mindestens eine erste leitende Bahn (52) zwischen den zwei Isolierschichten besitzt zur elektrischen Verbindung des Stiftes mit dem Elektroniksystem, wobei eine zweite leitende Bahn (62, 64, 65) sich auf der ersten Oberfläche erstreckt und eine dritte leitende Bahn (70, 74, 76, 78) sich auf der zweiten Oberfläche erstreckt und wobei die Flügel in der Lage sind, zumindest teilweise zurück aufeinander gefaltet zu werden, um den Pin einzukapseln, wobei die zweiten und dritten leitenden Bahnen in der Lage sind elektrisch miteinander verbunden zu werden mindestens dann, wenn die Flügel mindestens teilweise zurück aufeinander gefaltet sind, wodurch die zweiten und dritten leitenden Bahnen mindestens einen Teil einer Schutzbahn (protection track) bilden zur elektrischen Verbindung mit dem elektronischen System.

2. Vorrichtung nach Anspruch 1, wobei ein Abstandselement (24) zwischen dem Mittelteil (26) und den Flügeln (28, 32, 36, 40) angeordnet ist.

3. Vorrichtung nach Anspruch 2, wobei das Abstandselement (24) eine zusätzliche Öffnung (84) aufweist, in die der Pin einzusetzen (14) ist.

4. Vorrichtung nach Anspruch 2 oder 3, wobei das Abstandselement (24) eine mit Gewinde versehene Öffnung (84) aufweist und die Vorrichtung (20) eine Schraube (91) mit einem mit Gewinde versehenen Stift (92) aufweist, der in der Lage ist mit der mit Gewinde versehenen Öffnung zusammenzuarbeiten und mit einem Kopf (93), der in der Lage ist die Flügel (28, 32, 36, 40) gegen das Abstandselement (24) zu legen.

5. Vorrichtung nach irgendeinem der vorhergehenden Ansprüche, wobei die zweiten und dritten leitenden Bahnen (62, 68, 72) aus Kohlenstoff hergestellt sind.

6. Vorrichtung nach irgendeinem der vorhergehenden Ansprüche, wobei die dritte leitende Bahn einen verbreiterten leitenden Teil (76, 78) auf dem Niveau eines ersten Flügels (32, 36) von den erwähnten Flügeln (28, 32, 36, 40) aufweist und wobei der verbreiterte leitende Teil in der Lage ist, an die erste Oberfläche (46) eines zweiten Flügels (40, 36) von den erwähnten Flügeln angeklebt zu werden.

7. Vorrichtung nach einem der vorhergehenden Ansprüche, wobei die zweite leitende Bahn (62) einen ersten leitenden Steg (64, 65) aufweist, und zwar auf dem Niveau eines ersten Flügels (28) von den Flügeln (28, 32, 36, 40) und wobei die dritte leitende Bahn einen zweiten leitenden Steg (70, 74) auf dem Niveau eines zweiten Flügels (40) von den Flügeln aufweist, wobei die ersten und zweiten Flügel in der Lage sind zurück gegeneinander gefaltet zu werden, um den ersten leitenden Steg in elektrischen Kontakt mit dem zweiten leitenden Steg zu bringen.

8. Verfahren zum Schutz einer elektronischen Komponente (10), die mindestens einen Stift (14) zur elektrischen Verbindung mit einem elektronischen System aufweist, wobei das Verfahren die folgenden Schritte aufweist:
Vorsehen einer Schutzvorrichtung, die mindestens eine flexible gedruckte Schaltung (22) aufweist, die erste und zweite entgegengesetzte Oberflächen (46, 47) besitzt, ferner einen Mittelteil (46), der eine Durchgangsöffnung (48) aufweist und ferner Klappen oder Flügel (28, 32, 36, 40) verbunden mit dem Mittelteil, wobei die flexible gedruckte Schaltung mindestens teilweise aus einem Stapel aus zwei Isolierschichten (94, 98) gebildet ist und mindestens eine erste leitende Bahn (52), zwischen den zwei Schichten aufweist, ferner eine zweite leitende Bahn (62), die sich auf der ersten Oberfläche erstreckt, und eine dritte leitende Bahn (68, 72), die sich auf der zweiten Oberfläche erstreckt;
Einsetzen des Stiftes in die Öffnung;
Verbinden der ersten leitenden Bahn mit dem Stift; und
mindestens teilweises Zurückfalten der Flügel gegeneinander, um den Stift einzukapseln, wobei die zweiten und dritten leitenden Bahnen in der Lage sind elektrisch miteinander verbunden zu werden dann, wenn die Flügel mindestens teilweise zurück aufeinander gefaltet sind, wodurch die zweiten und dritten leitenden Bahnen eine Schutzbahn bilden, und zwar zur elektrischen Verbindung mit dem elektronischen System.

9. Verfahren nach Anspruch 8, wobei ferner die folgenden Schritte vorgesehen sind:
Anordnung eines Abstandselements (24) am Mittelteil (26) und mindestens teilweises Zurückfalten der Flügel (28, 32, 36, 40) gegen das Abstandselement.

10. Verfahren nach Anspruch 8 oder 9, wobei die dritte leitende Bahn (68, 72) einen erweiterten leitenden Teil (76, 78) auf dem Niveau eines ersten Flügels (32, 36) von den erwähnten Flügeln (28, 32, 36, 40) aufweist, und wobei das Verfahren ferner den Schritt des Klebens des verbreiterten leitenden Teils an die erste Oberfläche (46) der zweiten Flügel (40, 36) von den Flügeln umfasst.
